# EUROPÄISCHE PATENTANMELDUNG

(11) **EP 0 609 564 A2**
(43) Veröffentlichungstag der Anmeldung: **10.08.1994**
(21) Anmeldenummer: 93120991.0
(22) Anmeldetag: 28.12.1993
(51) Int. Cl.: H02J 7/10

(54) **Verfahren und Vorrichtung zum Aufladen einer Batterieeinheit**

(30) Priorität: 05.01.1993 DE 4300097
(71) Anmelder: Böcker, Renate, D-49509 Recke (DE)
(72) Erfinder: Böcker, Renate, D-49509 Recke (DE)

(57) **Zusammenfassung**

Um ein definiertes Laden und ein vollständiges Ausnutzen einer Batterie-Einheit zu ermöglichen, werden mit einer Rechnereinheit
- Zellen (1.1, 1.2, 1.3 ... 1.n) durch Transistoren (2.1, 2.2, ... 2,n) mit dazugehörigen Kollektorwiderständen (17.1, 17.2, ...) einzeln herausgeschaltet;
- jede der Zellen (1.1, 1.2, 1.3 ... 1.n) geprüft; dieKollektorwiderstände (17.1, 17.2,...) sind dabei zugleich Lastwiderstände zum Entladen der Zellen (1.1, 1.2, 1.3 ... 1.n) und Nebenwiderstände zur Aufnahme des Ladestroms bei voll geladener Zelle (1.1, 1.2, 1.3 ... 1.n);
- jede der Zellen (1.1, 1.2, 1.3 ... 1.n) einzeln aufgeladen oder
- jede der Zellen (1.1, 1.2, 1.3, ... 1.n) einzeln entladen und danach aufgeladen.

## Beschreibung

Die Erfindung betrifft ein Verfahren und eine Vorrichtung zum Aufladen einer Batterieeinheit.

Aufladbare Batterieeinheiten, sogenannte Akkumulatoren oder kurz Akkus genannt, erfreuen sich nicht zuletzt aufgrund ihrer Wiederverwendbarkeit einer steigenden Beliebtheit. Ob im Walkan oder Spielzeugauto, im Camcorder, im drahtlosen Telefon oder in Filmkameras u.dgl., die Einsatzbereiche der netzunabhängigen Stromquelle steigen von Jahr zu Jahr. Nickel/Cadmium-(Ni-Cd)Akkus weisen die höchste Steigerungsrate auf.

Aus Sicherheitsgründen lädt der Benutzer die Batterieeinheit viel zu früh auf. Durch dieses ständige Nachladen entsteht ein sogenannter "Memory"-Effekt. Das Nachladen ab einer bestimmten noch vorhandenen Restkapazität führt zu chemischen Veränderungen in den einzelnen Zellen. Diese Veränderungen bewirken, daß die Zellen nicht mehr in der Lage sind, Strom abzugeben. Die Folge ist, daß die gesamte Batterieeinheit nur noch mit einer Kapazität von 30 - 50 % der ursprünglichen betreibbar ist. Nachteilig wirkt sich darüber hinaus noch aus, daß für die Anzeige Werte über die gesamten zusammengeschalteten Zellen abgegriffen werden. Bei dieser Art des Messens bestimmt aber die schwächste Zelle innerhalb des Zellenverbandes die Endwerte. Allein schon durch fertigungstechnische Toleranzen kann eine der Zellen über niedrigere Spannungs- bzw. Kapazitätswerte verfügen. Die einzelne Zelle kann darüber hinaus bereits nach kürzester Zeit defekt sein. So werden die übrigen intakten Zellen entweder nicht voll, was den "Memory"-Effekt noch verstärkt, oder gar nicht ausgelastet. In beiden Fällen wird die gesamte Batterieeinheit wesentlich zu früh einer Entsorgung zugeführt, da sie den Einsatzanforderungen nicht mehr entspricht. Es wundert daher nicht, daß bei jährlich zweistelligen Zuwachsraten bei NiCd-Akkus auch der Nickel/Cadmium-Müllberg ständig wächst. Neben einer teuren Wiederaufbereitung von NiCd-Akkus findet ein nicht unerheblicher Teil der NiCd-Akkus nicht den Weg zurück zum Hersteller bzw. wird nicht sachgemäß entsorgt. Hierdurch entsteht eine wachsende Gefahrenquelle. Als Alternative hierzu wird zum giftigen Cadmium eine Nickel-Metallhydrid-Batterieeinheit (NiMH) zum Einsatz gebracht, die in gleicher Art und Weise fehlerhaft gebraucht wird.

Aus der DE-A 3 326 729 ist es bekannt, zum Betrieb eines elektrochemischen Speichers die in Reihe geschalteten Zellen in Gruppen herauszuschalten und zu entladen. Auch wenn die Zellengruppe dann wieder aufgeladen wird, hat diese Ent- und Aufladung einzig und allein das Ziel, ungleichmäßige Abscheidungen an den Elektroden zu vermeiden. Eliminiert werden sollen damit parasitäre Ströme.

Die DE-A 2 928 503 beschreibt ein Verfahren und eine Vorrichtung zur Voll- und/oder Ausgleichsladung von mehrzelligen Akkumulator-Batterien bei begrenzter Gesamtspannung. Dabei lädt ein Hauptgleichrichter die gesamte Akkumulator-Batterie in ihrer Gesamtheit auf, während ein Hilfsgleichrichter über Schaltelemente auf einzelne Zellengruppen geschaltet wird. Geladen wird mit einem zulässigen Ladestrom nach DIN 57310/VDE 0510.

In der DE-Zeitschrift EET: "Akku-EKG, 4/92, S.8, 9" ist ein Akku-Test-System angegeben, das mit Hilfe eines Rechners eine beliebige Anzahl Akku-Zellen in drei Zustände (Trestate) schalten kann:
- Zelle in Ladestromkreis geschaltet,
- Zelle in Entladestromkreis geschaltet,
- Zelle galvanisch getrennt.
Allerdings werden während der gesamten Testzeit die Meßwerte nur dazu in einem Takt von 4 Sekunden erhoben und im ASCII-Format auf der Festplatte gespeichert, um z.B. mit Hilfe eines umfangreichen Auswerteprogramms ausgewertet zu werden.

Der Erfindung liegt die Aufgabe zugrunde, die vorstehend genannten Nachteile bei einem Verfahren und einer Vorrichtung zum Aufladen einer Batterieeinheit der eingangs genannten Art zu beseitigen und ein Verfahren und eine Vorrichtung zum Aufladen einer Batterieeinheit anzugeben, die ein definiertes Laden und ein vollständiges Ausnutzen der Batterieeinheit ermöglichen.

Gelöst wird diese Aufgabe bei einem Verfahren zum Aufladen einer Batterieeinheit, die aus einzelnen Zellen besteht, mit einer Rechnereinheit in folgenden Schritten:
a) Herausgeschalten der einzelnen Zellen aus der Batterieeinheit;
b) Belasten der Zellen und Prüfen ihrer Zellspannung;
c) Entladen jeder Zelle, wenn bei der Prüfung im Schritt b) festgestellt wurde, daß wenigstens eine der Zellen einen festgelegten Minimalwert der Zellenspannung unterschreitet;
d) Abschalten aller Belastungen, Aufladen der Zellen innerhalb einer festgelegten Ladezeit und Hochzählen der Kapazität;
e) Kapazitätstest der einzelnen geladenen Zellen in Zeitintervallen und Speicherung der gemessenen Werte der Zellenspannung jeder einzelnen Zelle;
f) Nachladen, Entladen oder Ersetzen der einzelnen Zellen in Abhängigkeit einer Selbstentladung innerhalb der Zeitintervalle.

Die mit der Erfindung erzielten Vorteile bestehen insbesondere darin, daß der aus einer gruppenweisen Zusammenschaltung von Einzelzellen bestehende Zellenverband elektrisch in einzelne Zellen getrennt wird. Die einzelnen Zellen können dabei zur Erreichung einer geforderten Batteriespannung in Reihe geschaltet bzw. zur Erlangung einer geforderten Batteriekapazität auch parallel geschaltet sein. Durch die elektrische Vereinzelung der Zellen ist es möglich, den Ladezustand jeder Zelle korrekt zu überprüfen. In Abhängigkeit von dieser Überprüfung wird entschieden, ob die einzelne Zelle sofort aufgeladen oder definiert entladen und danach vollständig aufgeladen wird. Durch diese Form des Ladens der einzelnen Zellen wird gesichert, daß jede Zelle vollständig aufgeladen wird. Durch das definierte Entladen ab einer bestimmten Grenze wird darüber hinaus eine chemische Veränderung innerhalb der Batterie vermieden. Dadurch bleibt der sogenannten "Memory"-Effekt aus. Die Batterieeinheit ist aufgrunddessen in der Lage, ihre gesamte Kapazität an den jeweiligen Verbraucher voll abzugeben. Das führt insbesondere zu dem Vorteil, daß die gesamte Batterieeinheit ihre Lebensdauer fast verdoppeln kann bzw. die Hälfte der Nickel-Cadmium-Batterieeinheiten nicht mehr der Entsorgung zugeführt werden. Das führt nicht nur zu einer Erhöhung der Betriebssicherheit von Filmkameras, drahtlosen Telefonen u.dgl., sondern darüber hinaus zu dem viel bedeutenderen Effekt der Entlastung der Umwelt. Bei Nickel-Metallhydrid-Batterien (NiMH) wird die Nutzung dieser sehr kostspieligen Akkumulatoren wesentlich wirtschaftlicher gestaltet.

Vorteilhaft ist es, wenn ab dem Verfahrensschritt d) fortgefahren wird, wenn bei der Messung b) festgestellt wurde, daß mehr als 50% der Zellen Nennspannung haben. Durch diese Maßnahme wird erreicht, daß der gesamte Vorgang des Aufladens abgekürzt wird.

In weiterer Ausgestaltung der Erfindung erfolgt nach dem Schritt a) eine Spannungsprüfung ohne Belastung und nur eine Aufladung der Zellen in einer festgelegten Zeit, vorzugsweise für 2 Sekungen, wenn die Zellenspannung einer der Zellen um einen bestimmten Wert vorzugsweise 0,3 V, abgefallen ist.

Die Ladezeit in Schritt b) wird dabei vorteilhafterweise auf zwei Stunden begrenzt, während die Zeitintervalle in den Schritten d) und e) zwischen 5 Minuten bis hin zur Ladungsdauer betragen. Hierdurch wird erreicht, daß das Entstehen eines "Memory-Effektes" vermieden und dadurch die Lebensdauer der gesamten Batterieeinheit wesentlich verlängert wird. Damit wird nur noch die Hälfte der aus Nickel-Cadmium bestehenden Batterieeinheiten einer speziellen Entsorgung zugeführt werden müssen. Die sehr teuren NiMH-Batterien können wesentlich länger benutzt werden.

Die Vorrichtung zur Durchführung des Verfahrens weist auf:
- parallel zu den Zellen einer Batterieeinheit angeordnete Widerstände, die zu einem Mehrfach-Umschalter geführt sind, und Schalteinrichtungen und
- eine Rechnereinheit, die den Mehrfach-Umschalter und die Schalteinrichtungen so ansteuert, daß
   a) die Zellen einzeln herausgeschaltet,
   b) jede der Zellen einzeln, gruppenweise und/oder im Gesamtverband geprüft werden und
   c) jede der Zellen einzeln aufgeladen oder
   d) jede der Zellen einzeln entladen und aufgeladen wird und
   e) jede Zelle geprüft, nachgeladen oder für eine Ersetzung freigegeben wird.

Dabei ist es von Vorteil, wenn die die Schalteinrichtungen gruppenweise über Ein-/Ausgabebausteine ansteuerbar sind. Hierdurch ist eine besondere und gezielte Erfassung einzelner belasteter Zellen feststellbar.

Vorteilhaft ist es, wenn zwischen dem ersten Ein-/Ausgabebaustein und wenigstens den ersten vier Schalteinrichtungen jeweils wenigstens vier weitere Schalteinrichtungen angeordnet sind. Die Anzahl der zusätzlichen Schalteinrichtungen bestimmt sich dabei durch die Gesamtanzahl der einzelnen Zellen. Ist ihre Anzahl sehr hoch, ist es möglich, daß weitere zusätzliche Schalteinrichtungen angeordnet werden. Durch diese zusätzlichen Schalteinrichtungen ist es möglich, die Steuerung der Zellenspannungen der Zellen elektronisch beherrschen zu können.

Vorteilhaft ist es, wenn über eine einzelne Schalteinrichtung die Zellen der gesamten Batterieeinheit ansteuerbar sind und ihr Zustand über die Ein-/Ausgabebausteine durch Anzeigeeinrichtungen anzeigbar ist. Mit dieser einzelnen Schalteinrichtung wird gezielt der Prüfungs- und Anzeigevorgang eingeleitet und durchgeführt. Hierdurch ist es möglich, den Zustand der gesamten Batterieeinheit nach außen hin anzuzeigen.

Vorteilhaft ist es, wenn die Schalteinrichtung als ein mit einem Kollektorwiderstand beschalteter Transistor ist, dessen Basis an einem Widerstand anliegt, wobei der Kollektorwiderstand zugleich ein Lastwiderstand zum Entladen der Zelle und ein Nebenwiderstand zur Aufnahme des Ladestroms bei voll geladener Zelle ist.

Vorteilhaft ist es, daß die weitere Schalteinrichtung aus einem Transistor besteht, dessen Emitter-Widerstand zugleich der Basiswiderstand des ersten Transistors ist und dessen Basis an einem weiteren Widerstand anliegt.

Vorteilhaft ist es, daß die einzelne Schalteinrichtung ein Transistor ist,
- dessen Basis an einer Verbindung einer Reihenschaltung eines Widerstandes, der mit einem Ausgang der zweiten Ein-/Ausgabeeinheit verbunden ist, mit einer Zener-Diode, die zum Mehrfach-Umschalter führt, liegt,
- dessen Emitter über einen Widerstand gleichfalls zum Mehrfach-Umschalter führt und
- dessen Kollektor an einer von der Recheneinheit beaufschlagten Steuerleitung (Akku), die mit der letzten Zelle verbunden ist, liegt, wodurch ein definierter Aufladestrom anlegbar ist.

Vorteilhaft ist es, wenn die Rechnereinheit ein herkömmlicher Mikrorechner ist, die wenigstens
- eine zentrale Verarbeitungseinheit,
- einen Speicher,
- einen Lese-Schreib-Speicher,
- wenigstens eine Ein-/Ausgabeeinheit,
- einen Analog-Digital-Wandler,
- eine Adressen-Einheit und
- eine Daten-Einheit umfaßt,
die in bekannter Art und Weise zusammengeschaltet sind.

Selbstverständlich ist es auch möglich, eine anders konzipierte Rechnereinheit einzusetzen. Von besonderem Vorteil ist dabei, daß auf herkömmliche Bausteine zurückgegriffen werden kann, die über einzelne Platinen zusammengefaßt werden können. Durch den Einsatz einer derartigen Rechnereinheit als zentrale Steuereinheit ist gewährleistet, daß die gesamte Vorrichtung transportierbar ist. Hiermit wird gewährleistet, daß auch diese beschriebene Art und Weise des Ladens der Batterieeinheiten an Ort und Stelle durchgeführt werden kann. Selbstverständlich ist es auch möglich, ein Laden der Batterien in der beschriebenen Art und Weise zentral durchzuführen.

Vorteilhaft ist es, wenn die einzelnen Zellen mit Kontaktschleifen verbunden sind, die durch zusätzliche Anschlußausnehmungen hindurchragen, die in den Deckel des Gehäuses eingebracht sind. Mit diesen zusätzlichen Kontaktschleifen ist es möglich, die Batterieeinheit mit der Ladeeinheit zu koppeln. Sind die einzelnen Kontaktschleifen und die zusätzlichen Anschlußausnehmungen noch nicht angebracht, lassen sie sich einfach und sicher nachrüsten. Vorteilhaft ist es natürlich, wenn dieses bereits bei der Herstellung der Batterieeinheit geschieht. Hierdurch werden die notwendigerweise anfallenden Mehraufwendungen für die Nachrüstung vermieden.

Die Erfindung wird nachstehend an einem Ausführungsbeispiel näher erläutert. Es zeigen:

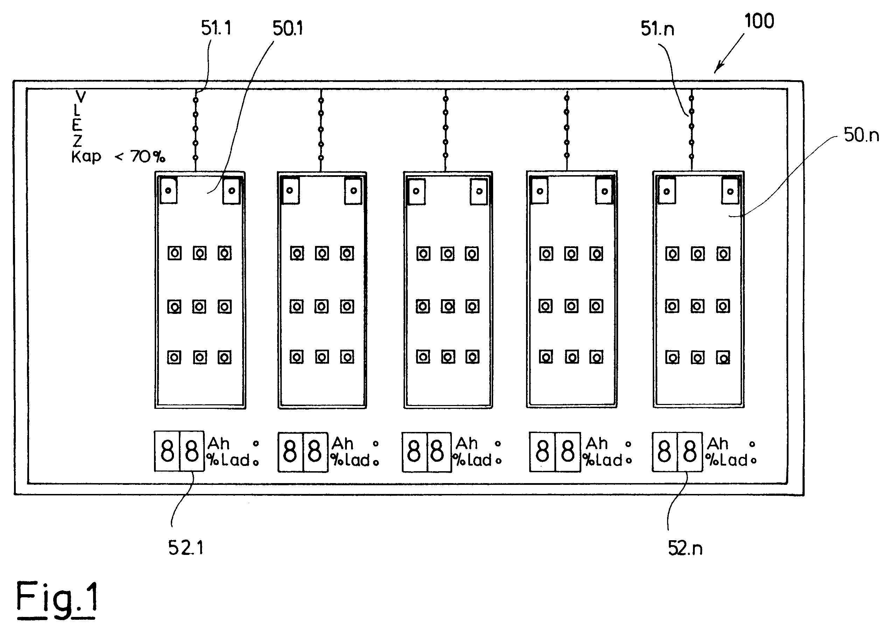

- Figur 1: eine Ladeeinheit mit mehreren aufzuladenenden Batterieeinheiten in einer schematisch dargestellten Draufsicht,
- Figur 2a: ein Gehäuse einer Batterieeinheit gemäß Figur 1 in einer schematisch dargestellten Draufsicht,
- Figur 2b: auf die Zellen einer Batterieeinheit aufgreifende Kontaktschleifen in einer schematischen Seitenansicht,
- Figur 2c: eine zum Aufladen vorbereitete einzelne Batterieeinheit gemäß Figur 1,
- Figur: 3 eine Teilschaltung einer Batterieladeschaltung in einer schematischen Darstellung und
- Figur 4: eine mit einer Teilschaltung gemäß Figur 3 zusammenarbeitende Rechnereinheit einer Batterieladeschaltung in einer schematischen Darstellung.

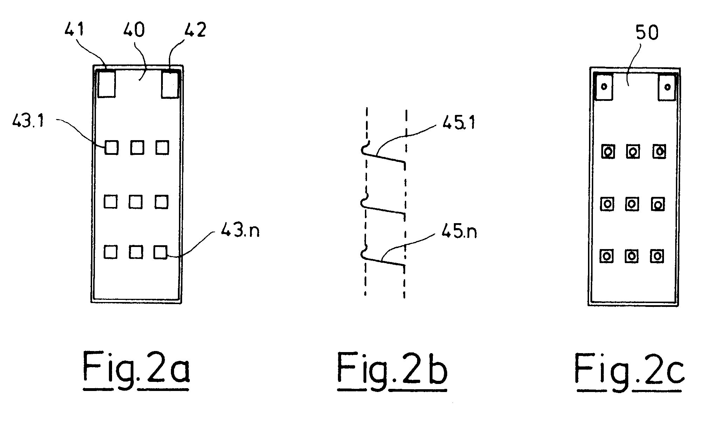

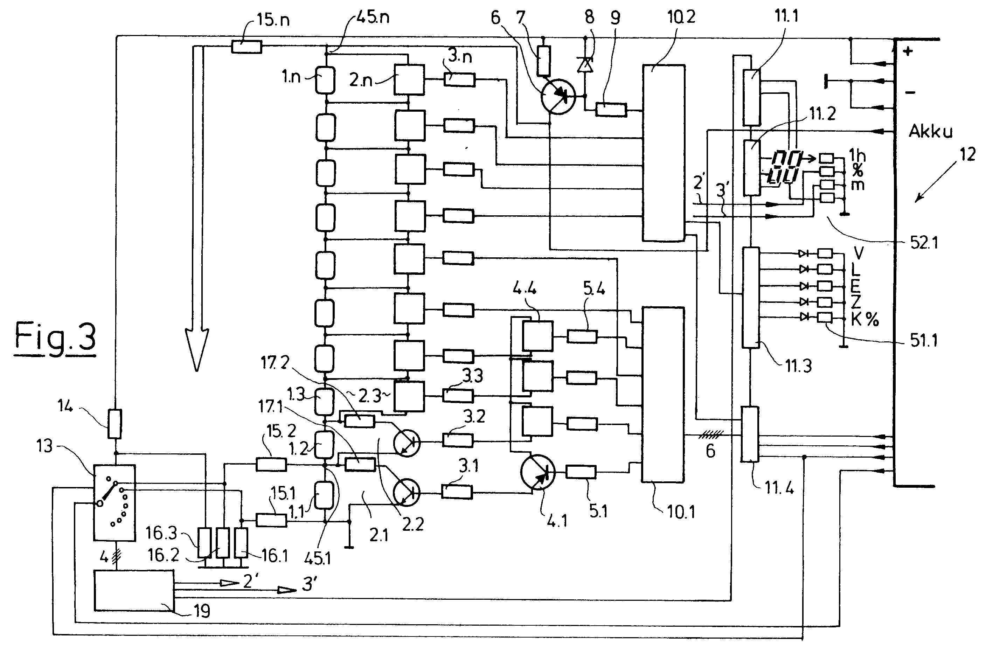

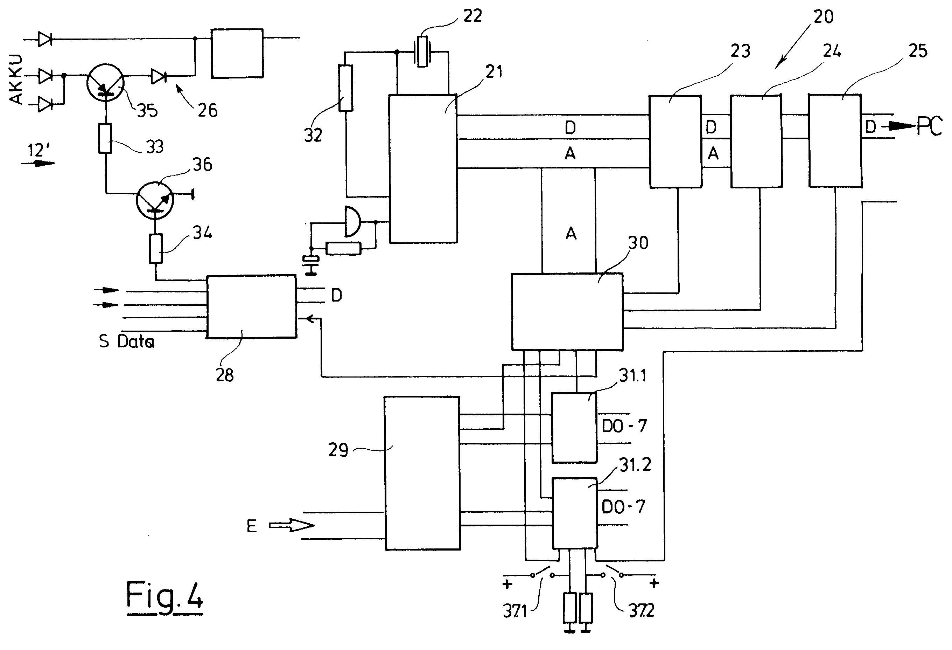

Eine Batterieeinheit 50, ein sogenannter aufladbarer Akkumulator oder kurz Akku genannt auf der Basis Nickel/Cadmium (Ni-Cd) oder Nickel-Metallhydrid (NiMH), besteht aus einem äußeren Gehäuse 40, an dem Anschlußausnehmungen 41 und 42, wie insbesondere aus den Figuren 2a bis 2c hervorgeht, angebracht sind. Über die Anschlußausnehmungen 41 und 42 ist so die Batterieeinheit in herkömmlicher Art und Weise aufladbar. In das Gehäuse 40 werden nun zusätzlich Anschlußausnehmungen 43.1, ... 43.n eingebracht. Die einzelnen Zellen 1.1, ... 1.n werden mit Kontaktschleifen 41.1, ... 45.n bestückt. Diese Kontaktschleifen sind doppelt ausgeführt, damit der Entladestrom eine Messung nicht beeinflußt. Die Kontaktschleifen 45.1, ... 45.n ragen durch die Anschlußausnehmungen 43.1, ... 43.n hindurch, so daß es möglich ist, eine in den Figuren 3 und 4 als Schaltung dargestellte Batterieladeeinrichtung zum Eingriff zu bringen.

In Figur 3 sind die einzelnen Zellen 1.1, ... 1.n als längliche Kästchen dargestellt. Zwischen den einzelnen Zellen sind die Kontaktschleifen 45.1, ... 45.n als jeweilige Kreuzungspunkte angedeutet. Beim Einschieben der Batterieeinheit 50 greifen so die Kontaktschleifen zwischen die Verbindungen der einzelnen Zellen 1.1, ... 1.n. Selbstverständlich ist es auch möglich, die Kontaktnahme in einer anderen bliebigen Form vorzunehmen. Die Anzahl der einzelnen Zellen 1.1, 1.2, 1.3, ... 1.n wird durch die Batteriespannung bzw. durch die geforderte Kapazität der Batterieeinheit 50 bestimmt.

Erfindungswesentlich ist, daß jeder der Zellen 1.1, 1.2, 1.3, ... 1.n ein Transistor 2.1, 2.2, ... 2.n mit einem zugehörigen Basiswiderstand 3.1, 3.2, 3.3, ... 3.n zugeordnet ist. Jeder der Transistoren 2.1, 2.2, ... 2.n ist als bipolarer NPN-Transistor ausgebildet. Selbstverständlich ist es auch möglich, einen PNP-Transistor oder ein beliebiges anderes Bauelement einzusetzen, das eine Quasi-Schaltungsfunktion ausübt. Jeder der Transistoren 2.1, ... 2.n greift über seinen Kollektor auf die Kontaktschleifen 45.1, ... 45.n. Auf der gegenüberliegenden Seite sind Widerstände 15.1, 15.2,...15.n bis zur letzten Zelle 1.n angelegt. Diese Widerstände sind mit Widerständen 16.1, 16.2, 16.3 verbunden, die an einen Mehrfachumschalter 13 geführt sind. Der Widerstand 14 wird auf einen mehrpoligen Stecker 12 geführt. In analoger Art und Weise sind die weiteren, nicht dargestellten Widerstände bis zum Widerstand 15.n mit dem Mehrfachumschalter 13 verbunden, so daß eine Messung von der letzten bis zur ersten Zelle 1.n, 1.1 in Richtung oder gegen die Richtung des stark ausgezogenen Pfeiles möglich ist. Zusätzlich sind im Mehrfachumschalter 13 Kontakte vorgesehen, die am Emitter der Transistoren 2.1, 2.2, 2.3, ... und den Kollektorwiderständen 17.1, 17.2, ... angeschlossen sind. Hierdurch ist feststellbar, ob das gesamte Gerät, d.h., die Transistoren 2.1, 2.2, 2.3 ... als Schalter ihre Funktion ausüben.

Die Widerstände 3.1, 3.2., 3.3 der ersten vier Transistoren 2.1, 2.2, 2.3, ... 4 sind mit weiteren Transistoren verbunden. Dabei liegen die Widerstände 3.2, 3.3, ... am Emitter der jeweiligen Transistoren 4.1, ... 4.4. An der Basis sind Widerstände 5.1, ... 5.4 angeschaltet, deren Ausgänge zu einem Ein-/Ausgabebaustein 10.1 geführt sind. Der 5. und 6. Ausgang sind direkt mit den Transistoren der ersten Transistorengruppe (..., 2.n) verbunden. Die danach geschalteten Transitoren 2.n sind über ihre Widerstände 3.n an einem Ein-/Ausgabebaustein 10.2 angeschlossen. Der Abschluß der letzten Zelle 1.n ist an eine Steuerleitung Akku zum mehrpoligen Stecker 12 geführt. Ein Transitor 6 mit einem dazugehörigen Widerstand liegt zwischen dieser Verbindung und an der Direktverbindung, die vom Widerstand 14 zum Pluspol des mehrpoligen Steckers 11 führt. Von dieser letztgenannten Verbindung führt eine Zusammenschaltung einer Zener-Diode mit einem Widerstand zu einem der Anschlüsse des Ein-/Ausgabebausteins 10.2. Zwischen dem Widerstand 9 und der Zener-Diode 8 ist die Basis des Transitors 6 angeschlossen. Die Eingänge der Ein-/Ausgabebausteine 10.1 und 10.2 führen zu einem weiteren Ein-/Ausgabebaustein 11.4, der ebenfalls am mehrpoligen Stecker 12 angeschlossen ist. Eine der Verbindungen des Ein-/Ausgabebausteins 10.2 liegt an einem Ein-/Ausgabebaustein 10.3, der zu einer Anzeigeeinrichtung 51.1 führt. Der darüberliegende Ein-/Ausgabebaustein 11.2 führt zu einer weiteren Anzeigeeinrichtung 52.1, mit der auch ein Ein-/Ausgabebaustein 11.1 verbunden ist. Die Ein-/Ausgabebausteine 11.1, 11.2, 11.3 und 11.4 sind untereinander verbunden, wobei der Ein-/Ausgabebaustein 11.1 mit einem Baustein 19 in Verbindung steht. Der Baustein 19 ist über zweiLeitungen mit den Ziffern 2' und 3' direkt mit der Anzeigeeinrichtung 52.1 verbunden.

Eine Kupplung 12' zum Stecker 12 schafft eine Verbindung zu einer Rechnereinheit 20. Selbstverständlich ist es auch möglich, daß zwischen dem Stecker 12 und der Kupplung 12' weitere Steckeinrichtungen vorhanden sind, zwischen denen eine oder mehrere Verbindungsleitungen angeordnet werden können. Die Art und Weise der Verbindungen kann beliebig ausgeführt werden und wird insbesondere bestimmt durch den konkreten Realisierungsfall.

Wie Fig. Fig. 4 zeigt, besteht die Rechnereinheit 20 aus einer zentralen Verarbeitungseinheit 21, an der ein Taktgenerator 22 mit einer Baueinheit 32 anliegt. Desweiteren verfügt die Rechnereinheit über eine Stromversorgung 26, die sich aus einem Transitor 35 mit einem Widerstand 33 und weiteren einzelnen, nicht näher bezeichneten Baueinheiten zusammensetzt. Der Widerstand 33 wird auf einen weiteren Transitor 36 mit einem dazugehörigen Widerstand 34 geführt, der an einer Ein-/Ausgabeeinrichtung 28 angeordnet ist, mit dem die einzelnen Datenausgänge verbunden sind. Der Transitor 36 mit dem dazugehörigen Widerstand 34 bilden eine Stromausfallreserve 27. Die Daten D werden zur zentralen Verarbeitungseinheit 21 geführt und vor dort über einen Speicher 23, einen Lese-Schreib-Speicher und eine weitere Ein-/Ausgabe abgegeben. Möglich ist es, diesen Datenausgang zu einem Personal-Computer PC zu führen, in dem entweder die Daten entsprechend aufbereitet oder vorbereitet werden können. Mit den Daten D0 - 7 werden Daten-Einheiten 31.1 und 31.2 angeschlossen. Die Daten-Einheit 31.2 ist über Ansteuereinrichtungen in Form von Schaltern 37.1 und 37.2 betätigbar. Beide Daten-Einheiten 31.1 und 31.2 sind mit einem Analog-Digital-Wandler 29 verbunden, der mit weiteren Eingängen E verknüpft ist. Der Analog-Digital-Wandler 29 und die Daten-Einheiten 31.1 und 31.2 arbeiten auf eine Adresseneinheit 30, die ihre Adressen A in den entsprechenden Adressenbus eingibt und direkt mit dem Speicher 23, dem Lese-Schreibspeicher 24 und der Ein-/Ausgabe 25 verbunden ist. Ein weiterer Anschluß zum PC besteht direkt zur Daten-Einheit 31.2. Diese hier grob skizzierten Bauelemente bilden eine spezielle Rechnerplatine. Diese Platine ist in bekannter Art und Weise herstellbar. Selbstverständlich ist es auch möglich, einen anderen Einplatinen-Rechner oder einen Mikrorechner als eine Rechnereinheit 20 einzusetzen.

Einzelne so beschriebene Batterieeinheitn 50.1, ... 50.n werden in eine Ladeeinheit 100 eingebracht. Jeder Batterieeinheit 50.1, ... 50.n sind die in den Figuren 3 und 4 dargestellte Ladevorrichtung zugeordnet. Selbstverständlich ist es auch möglich, eine zentrale Ladevorrichtung vorzusehen. Auf der oberen Seite der äußeren Platte der Ladeeinheit 100 sind die Anzeigeeinrichtungen 51.1, ... 5.1n eingebracht. Diese Anzeigen 51.1, ... 51.n geben folgende Batteriezustände wieder:
- V: Voll
- L: Laden
- E: Entladen
- Z: Zelle defekt
- Kap < 70 %: Kapazität der Batterieeinheit ist kleiner als 70 %.

Darunter liegen die Anzeigeeinrichtung 52.1, ... 52.n, die sowohl die Amperestunden als auch die prozentuale Angabe der vorhandenen Ladekapazität digital anzeigen.

Der eigentliche Steuerungsablauf insbesondere unter Hinweis auf Figur 3 wird wie folgt vorgenommen:
I. Eigentest der Batterieeinheit 50.1, ... 50.n mit Angabe der jeweiligen Software-Standardnummer.
II. Alle Ausgänge der Transitoren 2.1, ... 2.n werden zurückgesetzt.
III. Über den Mehrfachschalter 13 wird eine Spannungsprüfung, beginnend von der Zelle 1.1 über die Zelle 1.2 zur Zelle 1.3 bis zur Zelle 1.n hin vorgenommen. Ist die Zellenspannung größer 0,3 V, springt der Steuerungsablauf zum Programmpunkt VII.
IV. Die Ladespannung wird für 2 s eingeschaltet, danach wird unter Programmpunkt III verfahren.
V. Die Ladespannung wird eingeschaltet. Die Messung erfolgt wie unter Programmpunkt III. Ist jedoch die Spannung größer 0,8 V, springt der Steuerungsablauf nach Programmpunkt II.
VI. Die Ladespannung wird ausgeschaltet und der Steuerungsablauf verharrt in diesem Programmpunkt.
VII. Nachdem die Batterieeinheit 50.1, ... 50.n eingesteckt worden ist, werden alle Lastwiderstände der Transitoren 2.1, 2.2, 2.3, ... 2.n über den Zellen 1.1, 1.2, 1.3, ... 1.n für zwei Minuten eingeschaltet.
VIII. Die Zelle 1.1, 1.2, 1.3, ... 1.n wird über den Mehrfachumschalter 13 geprüft. Verfügen mehr als 50 % der Zellen 1.1, 1.2, 1.3, ... 1.n über 1,23 V (was der Nennspannung einer Nickel-Cadmium-Zelle entspricht), dann wird ohne ein Kapazitätstest nach dem Programmpunkt XI geladen.
IX. Jede Zelle 1.1, 1,2, 1.3, ... 1.n wird unter Last überprüft. Beträgt die Spannung je Zelle kleiner 1,00 V, wird diese Zelle nicht mehr entladen.
X. Geprüft wird die Spannung der Zellen 1.1, ... 1.n. Ist die Spannung einer einzelnen Zelle größer als 1,0 V, wird entsprechend dem Programmpunkt IX verfahren.
XI. Die daran anschließende Ladezeit wird auf maximal zwei Stunden begrenzt. Dabei wird jede der Zellen 1.1, 1.2, 1.3, ... 1.n einzeln aufgeladen.
XII. Danach werden die Zellen 1.1, 1.2, 1.3, ... 1.n geprüft und die gemessenen Maximalwerte für eine Delta-U-Kurve gespeichert.
XIII. Danach wird je Zelle 1.1, 1.2, 1.3, ... 1.n die Kapazität entsprechend bis zum maximalen Wert hochgezählt.
XIV. Sinkt die Spannung einer der Zellen 1.1, 1.2, 1.3, ... 1.n 10 mV unter den letzten Maximalwert ab, ist das Abschaltkriterium für die Zellen 1.1, 1.2, 1.3, ... 1.n erreicht und es wird auf Entladen geschaltet. Während der maximale Ladestrom 1,35 A beträgt, ist als Entladestrom für jede Zelle zur Erhaltungsladung 50 mA festgelegt.
   Wird für alle Zellen nicht auf Entladen entschieden, springt der Steuerungsablauf auf Programmpunkt XII.
XVI. Nachdem die Batterieeinheit 50.1, ... 50.n aufgeladen ist, werden alle Transitoren 2.1, 2.2, 2.3, ... 2.n ausgeschaltet. Danach folgt über 30 Minuten eine Impulsladung von 1/20 des Stroms über 1 s, dem sich eine Auszeit von 16 s anschließt.
XVII. Nach 30 Minuten werden die Zellen 1.1, 1.2, 1.3, ... 1.n einzeln gemessen und die gemessenen Werte gespeichert.
XVIII.Durch eine Erhaltungsladung werden alle Zellen 1.1, 1.2, 1.3, ... 1.n auf den gespeicherten Werten gehalten. Zellen mit einer geringeren Selbstentladung werden durch Entladen auf den Maximalwert gehalten.

Nach diesem Steuerungsablauf wird die Batterieeinheit 50.1, ... 50.n herausgezogen und die Werte 5 Minuten gespeichert. Danach wird die Batterieeinheit 50.1, ... 50.n wieder eingesteckt und geprüft, ob alle Zellen 1.1, 1.2, 1.3, ... 1.n um bis zu 30 mV gefallen sind. Ist das der Fall, wird unter dem Programmpunkt XVIII fortgefahren.

Wird einer der Schalter 37.1 bzw. 37.2 auf Regenerieren gedrückt, wird der Steuerungsablauf bis zum Programmpunkt XV abgearbeitet. Danach werden alle Zellen 1.1, 1.2, 1.3, ... 1.n entladen und die Kapazitätsmessung eingeleitet und ein Sprung auf den Programmpunkt IX vorgenommen.

Wird einer der Schalter 37.1, 37,2 auf Schnelleinsatz gedrückt, wird nach Erreichen des Programmpunktes III nicht in de Programmpunkt VII, sondern sofort in den Programmpunkt XI gesprungen.

Wird im Programmpunkt XV festgestellt, daß die schlechteste Zelle 1.1, 1.2, 1.3, ... 1.n < 70 % von der besten ist, dann wird die Anzeige Zelle definiert Z, d. h. Zellenfehler, ausgegeben. In diesem Fall ist zu entscheiden, ob diese einzelne Zelle aus dem Zellenverband herausgenommen wird und durch eine neue ersetzt wird oder ob die gesamte Batterieeinheit 50.1, ... 50.n ausgesondert wird.

Durch die besondere Art und Weise des Ladens der Batterieeinheit 50.1, ... 50.n ist es möglich, alle Zellen einzeln auf das gleiche Niveau zu bringen. Aus dieser Position kann nun entweder geladen oder entladen werden. Sollte eine Zelle etwas früher "voll" sein, so wird diese auf Erhaltungsladung geschaltet und die anderen werden weitergeladen, bis jede einzelne die sogenannte Delta-O-Kurve abgearbeitet haben. Damit ist gesichert, daß alle Zellen den gleichen Ladezustand aufweisen und somit eine optimale Betriebszeit bieten. Da diese Form der Behandlung der Batterieeinheit 50.1, ... 50.n die vorgesehene Lebensdauer (ca. 1500 Lade-Entlade-Zyklen) voll ausschöpft, kann davon ausgegangen werden, daß die Batterieeinheit 50.1, ... 50.n mindestens die doppelte Lebensdauer erreichen als bisher. Daraus folgend vermindert sich die Umweltbelastung der nur sehr schwer zu entsorgenden Nickel-Cadmium-Zellen auf wenigstens die Hälfte. Nickel/Cadmium-Akkus finden insbesondere Verwendung im Walkan, Spielzeugauto, im Camcorder, im drahtlosen Telefon, in Filmkameras o.dgl. und weisen die höchste Steigerungsrate auf. NiCd-Batterieeinheiten 50.1, ... 50.n verwenden als negative Elektrode das giftige Cadmium, so daß durch erfindungsgemäße Lösung die wachsende Umweltbelastung wesentlich herabgesetzt wird.

## Patentansprüche

1. Verfahren zum Laden einer Batterieeinheit, die aus einzelnen Zellen (1.1, ... 1.n) besteht, mit einer Rechnereinheit (20) in folgenden Schritten:
a) Herausgeschalten der einzelnen Zellen (1.1, ... 1.n) aus der Batterieeinheit (50.1, ... 50.n);
b) Belasten der Zellen (1.1, ... 1.n) und Prüfen ihrer Zellenspannung;
c) Entladen jeder Zelle (1.1, ... 1.n), wenn bei der Prüfung im Schritt b) festgestellt wurde, daß wenigstens eine der Zellen (1.1, ... 1.n) einen festgelegten Minimalwert der Zellenspannung unterschreitet;
d) Abschalten aller Belastungen, Aufladen der Zellen (1.1, ... 1.n) innerhalb einer festgelegten Ladezeit und Hochzählen der Kapazität;
e) Kapazitätstest der einzelnen geladenen Zellen (1.1, ... 1.n) in Zeitintervallen und Speicherung der gemessenen Werte der Zellenspannung jeder einzelnen Zelle (1.1, ... 1.n);
f) Nachladen, Entladen oder Ersetzen der einzelnen Zellen (1.1, ... 1.n) in Abhängigkeit einer Selbstentladung innerhalb der Zeitintervalle.

2. Verfahren nach Anspruch 1, dadurch gekennzeichnet, daß ab dem Verfahrensschritt d) fortgefahren wird, wenn bei der Messung b) festgestellt wurde, daß mehr als 50 % der Zellen (1.1, ... 1.n) Nennspannung haben.

3. Verfahren nach Anspruch 1 oder 2, dadurch gekennzeichnet, daß nach dem Schritt a) eine Spannungsprüfung ohne Belastung erfolgt und nur eine Aufladung der Zellen in einer festgelegten Zeit, vorzugsweise für 2 s, vorgenommen wird, wenn die Zellenspannung einer der Zellen (1.1, ... 1.n) um einen bestimmten Wert, vorzugsweise 0,3 V, abgefallen ist.

4. Verfahren nach Anspruch 1, dadurch gekennzeichnet, daß die Ladezeit im Schritt d) auf zwei Stunden begrenzt wird.

5. Verfahren nach Anspruch 1, dadurch gekennzeichnet, daß die Zeitintervalle in den Schritten d) und e) zwischen 5 Minuten bis hin zur Ladungsdauer betragen.

6. Vorrichtung zur Durchführung des Verfahrens nach einem der Ansprüche 1 bis 5, mit
- parallel zu Zellen (1.1, ... 1.n) einer Batterieeinheit (50.1, ... 50.n) angeordneten Widerständen (15.1, ... 15.n; 16.1, ... 16.n), die zu einem Mehrfach-Umschalter (13) geführt sind, und Schalteinrichtungen (2.1, ... 2.n) und
- einer Rechnereinheit (20), die den Mehrfach-Umschalter (13) und die Schalteinrichtungen (2.1, ... 2.n) so ansteuert, daß
a) die Zellen (1.1, ... 1.n) einzeln herausgeschaltet,
b) jede der Zellen (1.1, ... 1.n) einzeln, gruppenweise und/oder im Gesamtverband geprüft werden und
c) jede der Zellen (1.1, ... 1.n) einzeln aufgeladen oder
d) jede der Zellen (1.1, ... 1.n) einzeln entladen und aufgeladen wird und
e) jede Zelle (1.1, ... 1.n) geprüft, nachgeladen oder für eine Ersetzung freigegeben wird.

7. Vorrichtung nach Anspruch 6, dadurch gekennzeichnet, daß die Schalteinrichtungen (2.1, ... 2.n; 3.1, ... 3.n) gruppenweise über Ein-/Ausgabebausteine (10.1, 10.2) ansteuerbar sind.

8. Vorrichtung nach Anspruch 6 oder 6, dadurch gekennzeichnet, daß zwischen dem ersten Ein-/Ausgabebaustein (10.1) und wenigstens den ersten vier Schalteinrichtungen (2.1, 2.2, 2.3, ...; 3.1, 3.2, 3.3) jeweils wenigstens vier weitere Schalteinrichtungen (4.1, ... 4.4; 5.1, ... 5.4) angeordnet sind.

9. Vorrichtung nach wenigstens einem der Ansprüche 6 bis 8, dadurch gekennzeichnet, daß über eine einzelne Schalteinrichtung (6, 7) die Zellen (1.1, ... 1.n) der gesamten Batterieeinheit (50.1, ... 50.n) ansteuerbar sind und ihr Zustand (V, L, E, Z, Kap < 70 %) über die Ein-/Ausgabebausteine (10.1, 10.2) durch Anzeigeeinrichtungen (51.1, ... 51.n, 52.1, ... 52.n) anzeigbar ist.

10. Vorrichtung nach wenigstens einem der Ansprüche 6 bis 9, dadurch gekennzeichnet, daß die Schalteinrichtung als ein mit einem Kollektorwiderstand beschalteter Transistor (1.1, 1.2, 1.3) ist, dessen Basis an einem Widerstand (3.1, 3.2, 3.3, ... 3.n) anliegt, wobei der Kollektorwiderstand (17.1, 17.2,...) zugleich ein Lastwiderstand zum Entladen der Zelle (1.1, 1.2, 1.3, ... 1.n) und ein Nebenwiderstand zur Aufnahme des Ladestroms bei voll geladener Zelle (1.1, 1.2, 1.3, ... 1.n) ist.

11. Vorrichtung nach wenigstens einem der Ansprüche 6 bis 10, dadurch gekennzeichnet, daß die weitere Schalteinrichtung aus einem weiteren Transistor (4.1, ... 4.4) besteht, dessen Emitterwiderstand zugleich der Basiswiderstand (3.1, 3.2, 3.3, ... ) des ersten Transistors (1.1, 1.2, 1.3, ... ) ist und dessen Basis an einem weiteren Widerstand (4.1, ... 4.4) anliegt.

12. Vorrichtung nach wenigstens einem der Ansprüche 6 bis 11, dadurch gekennzeichnet, daß die einzelne Schalteinrichtung ein Transistor (6) ist,
- dessen Basis an einer Verbindung einer Reihenschaltung eines Widerstandes (7), der mit einem Ausgang der zweiten Ein-/Ausgabeeinheit (10.2) verbunden ist, mit einer Zener-Diode (8), die zum Mehrfach-Umschalter (13) führt, liegt,
- dessen Emitter über einen Widerstand (7) gleichfalls zum Mehrfach-Umschalter (13) führt und
- dessen Kollektor an einer von der Recheneinheit (50) beaufschlagten Steuerleitung (Akku), die mit der letzten Zelle (1.n) verbunden ist, liegt, wodurch ein definierter Ladestrom anlegbar ist.

13. Vorrichtung nach wenigstens einem der Ansprüche 6 bis 12, dadurch gekennzeichnet, daß die Rechnereinheit (20) eine herkömmliche Mikrorechnereinheit ist, die wenigstens
- eine zentrale Verarbeitungseinheit (21),
- einen Speicher (23),
- einen Lese-Schreib-Speicher (24),
- wenigstens eine Ein-/Ausgabeeinheit (25, 28),
- einen Analog-Digital-Wandler (29),
- eine Adressen-Einheit (30) und
- eine Daten-Einheit (31.1, 31.2) umfaßt,
die in bekannter Art und Weise zusammengeschaltet sind.

14. Vorrichtung nach wenigstens einem der Ansprüche 6 bis 13, dadurch gekennzeichnet, daß die einzelnen Zellen (1.1, ... 1.n) mit Kontaktschleifen (45.1, ... 45.n) verbunden sind, die durch zusätzliche Anschlußausnehmungen (43.1, ... 43.n) hindurchragen, die in den Deckel eines Gehäuses (40) eingebracht sind.
